# EUROPEAN PATENT APPLICATION

(11) **EP 1 717 864 A1**
(43) Date of publication of application: **02.11.2006**
(21) Application number: 05290922.3
(22) Date of filing: 27.04.2005
(51) Int. Cl.: H01L 29/78, H01L 21/8238, H01L 27/092

(54) **Method for managing the stress configuration in the channel of a MOS transistor, and corresponding integrated circuit.**

(71) Applicant: STMicroelectronics ( Crolles 2) SAS, 38926 Crolles (FR); Koninklijke Philips Electronics N.V., 5621 BA Eindhoven (NL)
(72) Inventor: Fiori, Vincent, 38360 Sassenage (FR); Orain, Stéphane, 38240 Meylan (FR); Ortolland, Claude, 73230 Farby (FR)
(74) Representative: Zapalowicz, Francis

(57) **Abstract**

The MOS transistor, for example the NMOS transistor (NMOS1) is covered with an upper layer, for example a Contact Etch Stop Layer (BCESL, LCESL, TCESL) having a non-uniform thickness and/or a non-uniform field of stresses.

## Description

The invention relates to the integrated circuits, and more particularly to the performance improvement of the CMOS devices.

Transistor scaling down has been the primary factor driving CMOS performance improvement for more than 30 years. Approaching the fundamental limits of transistor scaling drives the industry and the research community to actively search for alternative solutions. In this context, the use of strained-Si layers obtained by stress-engineering seems to be the solution to achieve transistor improvements. In fact, induced Strain is a low cost way to boost the CMOS technology.

The Contact Etch Stop Layer (CESL) for inducing strain is one of the possible solutions amongst all the feasible stress-engineering devices (strained-spacer, silicide, SiGe, strained-gate...).

The CESL consists in a nitride layer deposited by Plasma Enhanced Chemical Vapor Deposition. This layer is deposited full-sheet before to be covered by a dielectric layer in which conventional metallic contacts are formed (by etching and filling metal for example tungsten) in order to provide an electrical contact with the silicide zones of the source, drain and gate of the transistor. The CESL provides then a detection point during the etching of the contact. More precisely, when the nitride of the CESL is detected, one knows that the etching must continue for example for a predetermined duration in order to reach the silicide zones.

By modifying the radio frequency power, the intrinsic strain in the uniform deposited CESL can be compressive or tensile. Indeed, the electrons or holes mobility in the NMOS or PMOS devices can be enhanced depending on whether the channel is in compression or in tension.

For example, an uniformly strained CESL can increase the mobility of NMOS at low electrical field and the transistor drive current can be improved for NMOS but also for PMOS.

However, the use of the CESL has two major drawbacks.

On one hand, it is known that a compressive CESL is needed to optimize PMOS devices and a tensile CESL to optimize NMOS devices. But, because the CESL is uniformly deposited full-sheet, the performances of both NMOS and PMOS transistors cannot be enhanced using these deposited CESL.

On the other hand, the stress map in the channel is affected by the layout. So, it is very hard to insure the same performance to several transistors.

Thus, the simple use of the CESL does not enable to fully manage the stress configuration in the Si channel.

The invention intends to solve this problem.

An aim of the invention is to reach the best stress configurations that enable to have the best performance for both NMOS and PMOS devices.

Another aim of the invention is to obtain the maximum electrical performance for one type of transistor in a wide range of layouts.

According to one aspect of the invention, it is proposed a method for managing the stress configuration in the channel of a MOS transistor, said method comprising covering said transistor with an upper layer having a non-uniform thickness and/or an non-uniform field of stresses.

Although this upper layer may be any layer having a non-uniform thickness and/or an non-uniform field of stresses and aiming only at stressing the channel and thus improving the MOSFET performance, such an upper layer is advantageously a Contact Etch Stop Layer. As a matter of fact, such a Contact Etch Stop Layer is generally used in the fabrication of integrated circuits in order to provide a detection information of nitride during the etching of metallic contact of the transistors.

Thus, such an upper layer when constituted by a Contact Etch Stop Layer performs both a function of controlling precisely the stresses in the channel of the transistor and a function of etch stopping.

This three dimensional non-uniform upper layer is according to an aspect of the invention thus more powerful than a conventional uniform CESL. As a matter of fact, the stress in the channel can be controlled and so optimized by adjusting in particular the thickness of different zones of the upper layer (for example top, lateral and bottom zones of the layer). Then, in a wide range of layouts, the suitable combination of these three zones permits in particular to lead to the maximum electrical performance.

Further, this control can also be obtained by modifying in a non-uniform way thi field of stresses in the upper layer.

The transistor comprises source and drain regions formed in a semi-conductor substrate, as well as a gate region and isolating spacers located on the lateral sides of the gate region. According to a preferred embodiment on the invention, said upper layer comprises a top zone above the gate region, a bottom zone above the source and drain regions, and a lateral zone above the spacers. And, at least one of these three zones has a thickness different of the thickness from at least another zone and/or a field of stresses different from the field of stresses of at least another zone.

As a matter of fact, it has been observed that each of theses three zones has a different impact on the state of stress of the channel.

Although it would be possible to selectively deposit portions of the upper layer having directly different thickness and/or different field of stresses, it is particularly advantageous and simple that said covering step comprises covering the transistor with an initial layer, for example an initial CESL, having a uniform thickness an a uniform field of stresses, and then processing said initial layer for obtaining said upper layer or final CESL.

Said processing step may comprise patterning said initial layer, for example etching partially and locally said initial layer.

According to a variant of the invention, the processing step may comprise relaxing locally the stresses of the initial layer, for example by using a germanium implantation.

According to another aspect of the invention, it is also proposed a method for managing the stress configuration in the channel of at least one MOS transistor having a channel of a first type of conductivity, for example a NMOS, said MOS transistor being formed in a semi-conductor integrated circuit including at least another transistor MOS having a channel of a second type of conductivity, for example a PMOS transistor. Said method comprises thus selectively performing on said at least one MOS transistor, the covering step as defined above.

According to an embodiment of the invention, the method further comprises covering all the transistors with an initial layer having an uniform thickness and an uniform field of stresses, masking said at least another MOS transistor, for example the PMOS transistor, and processing the unmasked part of said initial layer for obtaining the upper layer covering said at least one MOS transistor, for example the NMOS transistor.

According to another aspect of the invention, it is also proposed an integrated circuit comprising at least one MOS transistor covered with an upper layer having a non-uniform thickness and/or a non-uniform field of stresses.

Said upper layer is for example a Contact Etch Stop layer.

According to an embodiment of the invention, said upper layer comprises a top zone above the gate region, a bottom zone above the source and drain regions, and a lateral zone above the spacers of the transistor. And, at least one of these three zones has a thickness different from the thickness of at least another zone and/or a filed of stresses different from the field of stresses of at least another zone.

For example, one of theses three zones has a concentration of germanium different from the concentration of germanium of at least another zone.

According to an embodiment of the invention in which the integrated circuit comprises at least one MOS transistor, for example a NMOS transistor, having a channel of a first type of conductivity, and at least another MOS transistor, for example a PMOS transistor, having a channel of a second type of conductivity, said another MOS transistor is covered with another upper layer having a non-uniform thickness and/or a non-uniform field of stresses, the thickness parameters and/or the stress parameters of both upper layers (covering respectively the NMOS transistor and the PMOS transistor) are different.

Other advantages and features of the invention will appear on examining the detailed description of embodiments, these being in no way limiting, and of the appended drawings in which:
- figure 1 illustrates diagrammatically a first embodiment of an integrated circuit according to the invention,
- figures 2, 3 and 4 illustrate the impact of three zones of a CESL according to the invention, separately on the resulting average stress in X, Y or Z direction in the channel versus the gate length,
- figure 5 illustrates diagrammatically another embodiment of an integrated circuit according to the invention, and
- figures 6-9 illustrate diagrammatically flow charts related to several embodiments of the method according to the invention.

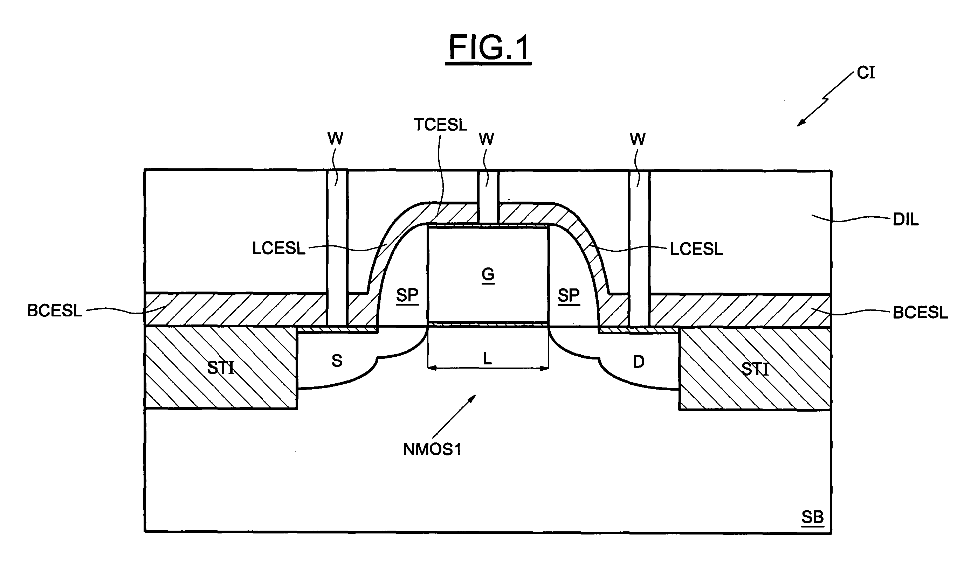

On figure 1, reference CI designates an integrated circuit comprising here a NMOS transistor referenced NMOS1. This transistor NMOS1 is realized within and above a semi-conductor substrate SB. The transistor comprises conventionally an active zone delimited by an isolation zone STI, for example of the Shallow Trench Isolation type. The active zone comprises a source region S and drain region D.

An isolated gate region G is formed above the active zone and has a length L which represents also the length of the channel of the transistor.

Conventionally, the transistor comprises also isolating spacers SP located laterally on the sides of the gate region G.

The transistor NMOS1 is covered by an upper layer which is here a nitride Contact Etch Stop Layer CESL.

On figure 1, the thickness of this upper layer CESL is not uniform. More precisely, this upper layer CESL comprises three zones:
- a top zone referenced TCESL above the gate region,
- a bottom zone referenced BCESL above the source and drain regions, and also above the STI region,
- a lateral zone referenced LCESL which is located above the spacers SP.

This non-uniform upper layer is covered by a dielectric layer DIL within which metallic contact W have been formed in a well known manner in order to provide an electrical contact with the silicide regions located on the top of the source, drain and gate regions.

Each of the three zones BCESL, LCESL and TCESL has a different impact on the state of stress in the channel of the transistor.

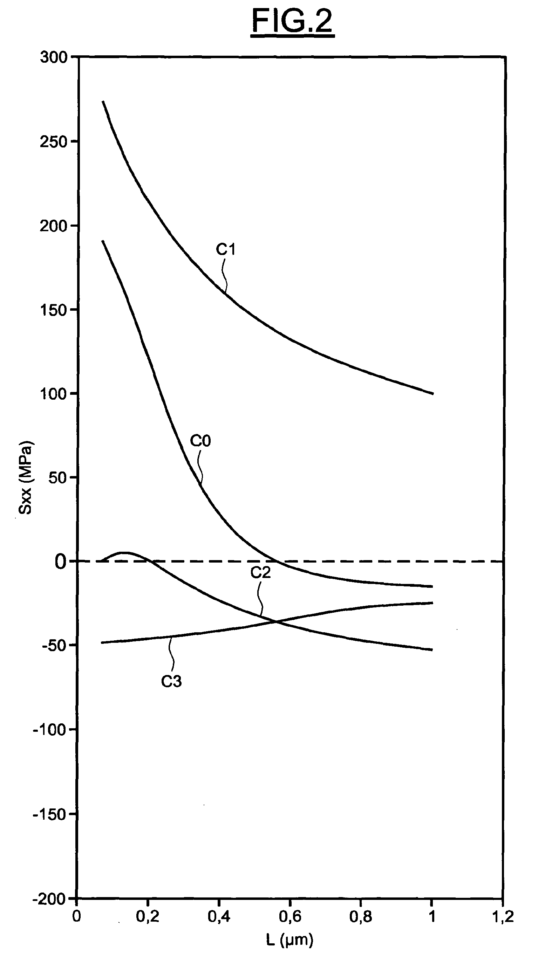

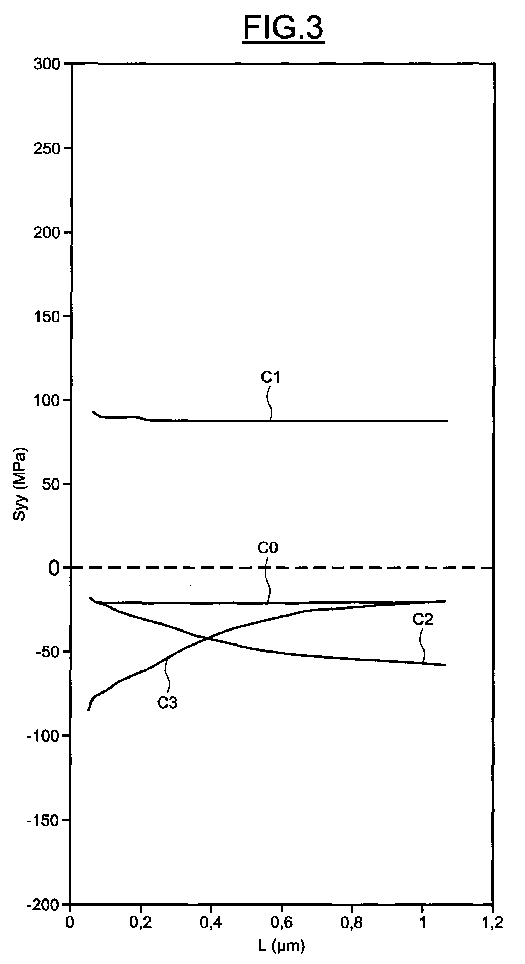

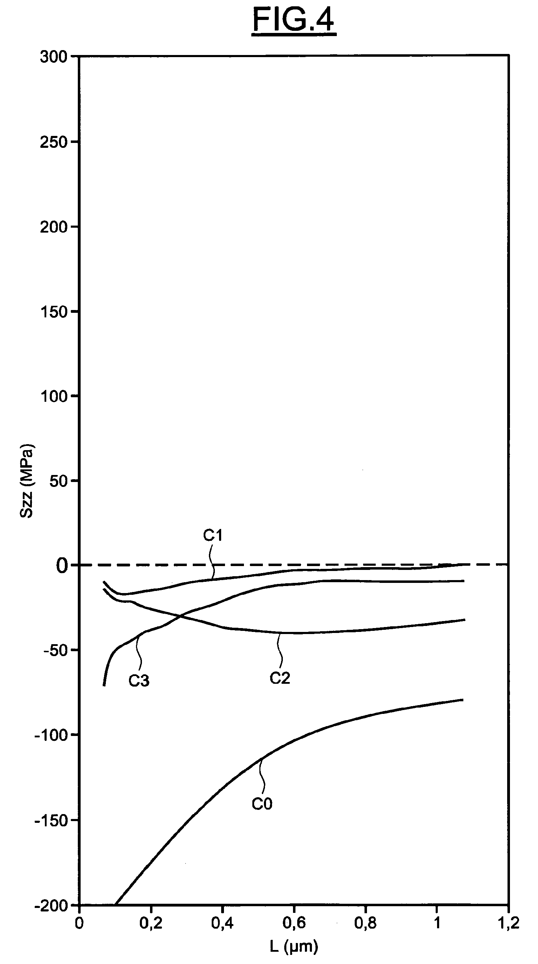

The contribution of the three zones separately (top, bottom and lateral) on the resulting stress in X, Y or Z direction in the channel for several gate widths (from L=65 nm to 1 µm) stressed by a nitride layer having an intrinsic stress of 1GPa and a thickness of 0,06 nm has been illustrated on figures 2, 3 and 4 respectively. The X direction is equal to the L direction whereas the Y direction, which is perpendicular to the X direction corresponds to width W of the channel. Z represents the vertical direction.

On each of these figures 2-4, curve C1 represents the impact of the sole bottom zone BCESL on the resulting average stress in X, Y or Z direction in the channel versus the gate length L.

Curve C2 represents the impact of the sole top zone TCESL on the resulting average stress X, Y or Z direction in the channel versus the gate length.

Curve C3 represents the impact of the sole lateral zone LCESL on the resulting average stress in X, Y or Z direction in the channel versus the gate length.

Finally, curve C0 represents the impact of a conventional uniform CESL covering the whole transistor on the resulting average stress.

It can be noted that the influence of each of these three zones depends on the gate width.

More precisely, the top-CESL leads to compressive stresses in the channel for large gates and its impact decreases with the reduction of the gate width and no effect is found for narrow gates (L=65nm).

The lateral-CESL leads to compressive stresses in the channel but its impact increases drastically when the gate width decreases.

The bottom-CESL adds tensile stresses in the channel and its impact increases also drastically when the gate width decreases.

It can be seen from these figures that stress in the channel can be in compression or in tension by adding two of the three CESL-zones in order to have the best stress configuration in the channel for NMOS or PMOS.

It has been observed that for a NMOS, it is advantageous to have a big ratio (for example greater than 100 %), and preferably as big as possible between the top CESL-zone and the lateral CESL-zone, whereas it is advantageous to have a small ratio (for example around 50 % or smaller), and preferably as small as possible between the top CESL-zone and the bottom CESL-zone.

For example, a top CESL-zone having a thickness equal to 35 nm, a lateral CESL-zone having a thickness equal to 35 nm and a bottom CESL-zone having a thickness equal to 21 nm (corresponding to a top/lateral ratio equal to 100 % and a top/bottom ratio equal to 60 %) leads to a gain on 1,2 % on the Iₒₙ current of the NMOS transistor with respect to a NMOS transistor covered with a conventional uniform CESL.

In another example, top, lateral and bottom CESL-zones having respectively thicknesses equal to 35 nm, 35 nm and 17,5 nm (corresponding to a top/lateral ratio and a top/bottom ratio respectively equal to 100 and 50 %) leads to a gain of 2 %.

And, top, lateral and bottom CESL-zones having respectively thicknesses equal to 52,5 nm, 35 nm and 17,5 nm (corresponding to top/lateral and top/bottom ratios respectively equal to 150 and 50 %) leads to a gain of 3 %.

These results are obtained for NMOS transistors having a gate length L equal to 65 nm and a gate width W equal to 1000 nm.

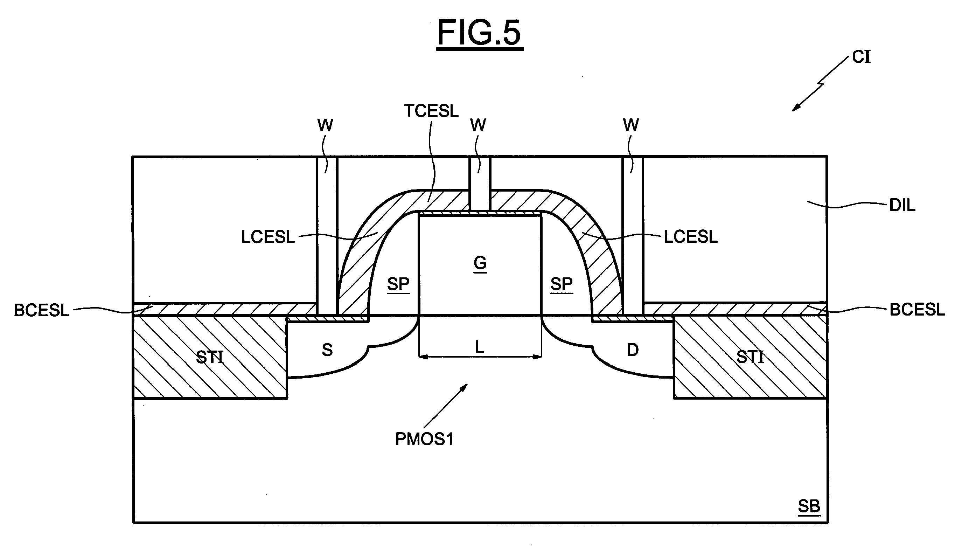

As illustrated in figure 5, the optimization of the upper layer is different from for a PMOS transistor PMOS1. More precisely, for a PMOS transistor, having for example a gate length L equal to 65 nm and a gate width W equal to 1000 nm, a top/lateral CESL-zone ratio is preferably as weak as possible, (for example around 50 % or smaller) whereas the top/bottom CESL ratio is preferably as big as possible, (for example greater than or equal to 150 %).

Departing from these general considerations about the different ratios, the man skilled in the art will be able to define precisely the desired pattern of the upper layer (3D-patterned layer according to the invention) depending on the desired mobility improvement of the transistor. A solution consists for example by electrically testing a lot of samples having upper layers with different thicknesses in order to finally find the best 3D-patterned layer for the desired mobility improvement.

Many possibilities exist for obtaining the upper (CESL) layer according to the invention.

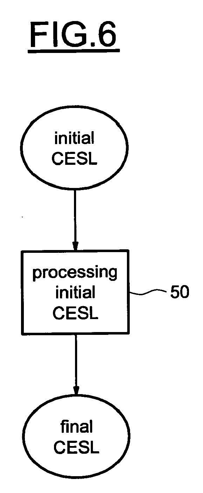

A particularly simple way of forming the upper layer is illustrated in Figure 6. More precisely, a conventional uniform initial CESL is formed, for example by deposition, over the transistor. Then, a processing step 50 is performed for processing he initial CESL in order to obtain the upper layer, i.e. the final CESL which is for example 3-dimensionally patterned in accordance with the desired stresses.

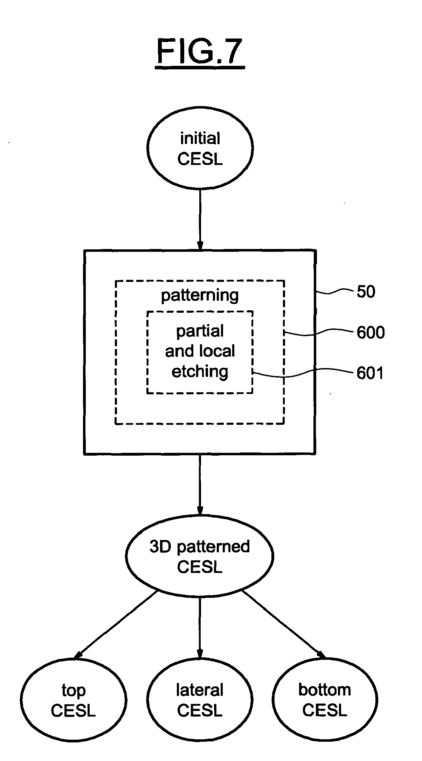

One solution for processing the initial CESL consists in patterning (step 600, Figure 7) said initial CESL, for example by etching partially and locally the initial CESL. Indeed, the top zone or the bottom zone of the CESL can be removed thanks to an anisotropic etch to obtain a 3D-patterned CESL.

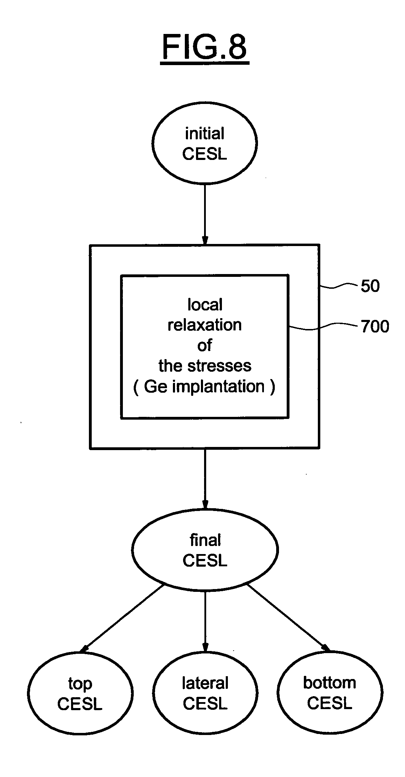

Another approach to process the initial CESL consists in locally relaxing the stress of the initial CESL (step 700, Figure 8) for example by germanium implantation.

Thus, in such a case, a modification of the thickness of the CESL may be not necessary.

As a matter of fact, relaxing for example the stress only in the lateral CESL-zone of a CESL having a uniformed thickness leads to a gain of 3,2 % with respect to a conventional CESL whereas relaxing the stresses only in the top CESL-zone leads to a gain of 0,2 %.

A solution for relaxing the stress of a CESL-zone having a thickness of 350 angströms and a stress of 1,2 GPa, consists for example, in making an implantation of germanium with an energy of 25 Kev and a quantity of 3,10¹⁴ atoms/cm³.

Of course, in some cases, it is possible to cover the transistor with an upper layer having both a non-uniform thickness and a non-uniform field of stresses.

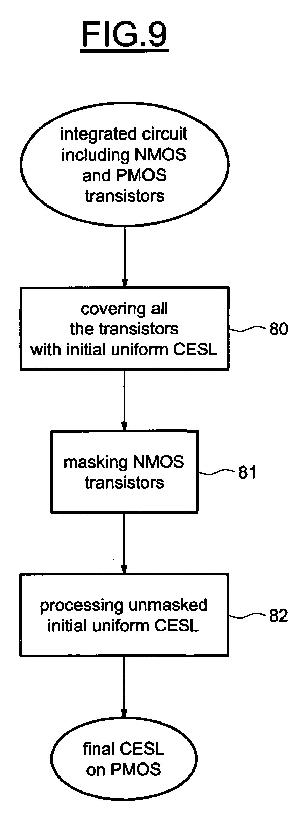

Figure 9 illustrates a possible solution to obtain the best patterned CESL for both NMOS and PMOS transistors included an integrated circuit.

In such a case, all the transistors are covered with an initial uniform CESL (step 80). Then, the NMOS transistors, for example, are masked (step 81) and the unmasked initial uniform CESL, i.e. the portion of the initial uniform CESL covering the PMOS transistors, is then processed (step 82) as described above (i.e. by patterning and/or by GE implantation) in order to obtain a final CESL on PMOS.

Then, the portion of the initial CESL covering the NMOS can be processed after having again masked the final CESL covering the PMOS transistors.

## Claims

1. Method for managing the stress configuration in the channel of a MOS transistor, comprising covering said transistor (NMOS1) with an upper layer (LCESL, BCESL, TCESL) having a non uniform thickness and/or a non uniform field of stresses.

2. Method according to claim 1, wherein said upper layer is a contact etch stop layer.

3. Method according to claim 1 or 2, wherein the transistor comprises source and drain regions formed in a semiconductor substrate, a gate region and isolating spacers located on the lateral sides of the gate region, wherein said upper layer comprises a top zone (TCESL) above the gate region, a bottom zone (BCESL) above the source and drain regions, and a lateral zone (LCESL) above the spacers, and wherein at least one of these three zones has a thickness different from the thickness of at least another zone and/or a field of stresses different from the field of stresses of at least another zone.

4. Method according to any one of the preceding claims, wherein said covering step comprises covering the transistor with an initial layer having a uniform thickness and a uniform field of stresses, and processing (50) said initial layer for obtaining said upper layer.

5. Method according to claim 4, wherein said processing step comprises patterning (600) said initial layer.

6. Method according to claim 5, wherein said patterning step comprises etching partially and locally (601) said initial layer.

7. Method according to claim 4, wherein said processing step comprises relaxing locally (700) the stresses of the initial layer.

8. Method according to claim 7, wherein said relaxing step (700) comprises a Germanium implantation.

9. Method for managing the stress configuration in the channel of at least one MOS transistor (NMOS1) having a channel of a first type of conductivity, said MOS transistor being formed in semiconductor integrated circuit including at least another transistor MOS (PMOS1) having a channel of a second type of conductivity, comprising selectively performing on at least one MOS transistor the covering step according to any one of claims 1 to 8.

10. Method according to claim 9, further comprising covering (80) all the transistors with an initial layer having a uniform thickness and a uniform field of stresses, masking (81) said at least another MOS transistor, and processing (82) the unmasked part of said initial layer for obtaining the upper layer covering said at least one MOS transistor.

11. Method according to claim 9 or 10, wherein said at least one MOS transistor is a NMOS transistor and said at least another MOS transistor is a PMOS transistor.

12. Integrated circuit comprising at least one MOS transistor, covered with an upper layer having a non uniform thickness and/or a non uniform field of stresses.

13. Integrated circuit according to claim 12, wherein said upper layer is a contact etch stop layer.

14. Integrated circuit according to claim 12 or 13, wherein the transistor comprises source and drain regions formed in a semiconductor substrate, a gate region and isolating spacers located on the lateral sides of the gate region, wherein said upper layer comprises a top zone above the gate region, a bottom zone above the source and drain regions, and a lateral zone above the spacers, and wherein at least one of these three zones has a thickness different from the thickness of at least another zone and/or a field of stresses different from the field of stresses of at least another zone.

15. Integrated circuit according to claim 14, wherein the transistor is a NMOS transistor, wherein the thickness of the top zone is greater than the thickness of the lateral zone, and the thickness of the top zone is smaller than the thickness of the bottom zone.

16. Integrated circuit according to claim 14, wherein the transistor is a PMOS transistor, wherein the thickness of the top zone is smaller than the thickness of the lateral zone and the thickness of the top zone is greater than the thickness of the bottom zone.

17. Integrated circuit according to anyone of claims 14 to 16, wherein at least one of these three zones has a concentration of Germanium different from the concentration of Germanium of at least another zone.

18. Integrated circuit according to any one of claims 12 to 17, wherein said at least one MOS transistor has a channel of a first type of conductivity, and further comprising at least another transistor MOS having a channel of a second type of conductivity and being covered with another upper layer having a non uniform thickness and/or a non uniform field of stresses, and wherein the thickness parameters and/or the stress parameters of both upper layers are different.

19. Integrated circuit according to claim 18, wherein said at least one MOS transistor is a NMOS transistor and said at least another MOS transistor is a PMOS transistor.
